(19) **Europäisches Patentamt / European Patent Office / Office européen des brevets**

(11) **EP 4 756 445 A1**

(12) # EUROPEAN PATENT APPLICATION

(43) Date of publication:
**10.06.2026 Bulletin 2026/24**

(21) Application number: **24218480.2**

(22) Date of filing: **09.12.2024**

(51) International Patent Classification (IPC):
**G01R 31/367** (2019.01)  **G01R 31/389** (2019.01)
**G01R 31/392** (2019.01)  **G01R 31/396** (2019.01)

(52) Cooperative Patent Classification (CPC):
**G01R 31/396; G01R 31/367; G01R 31/389;
G01R 31/392;** G01R 31/3835

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Heimdalytics GmbH**
**24145 Kiel (DE)**

(72) Inventors:
• **FRANKE, Fabian**
**24119 Kiel (DE)**

• **KRONENBERG, Felix**
**24103 Kiel (DE)**
• **PFAFF, Jakob**
**24149 Kiel (DE)**
• **WEBER, Christoph**
**24217 Schönberg (DE)**
• **VAN ZEYL, Clemens**
**Oakville ON L6J 3Y5 (CA)**

(74) Representative: **Maiwald GmbH**
**Elisenhof**
**Elisenstraße 3**
**80335 München (DE)**

(54) **MULTI-CHANNEL BATTERY DIAGNOSTIC DEVICE AND METHOD**

(57) The invention relates to a multi-channel diagnostic device (200) for diagnosing a battery module (102) consisting of a plurality of individual battery cell groups (118), comprising a first voltage measurement channel (210) for measuring a voltage of the battery module during a first measuring phase for determining an impedance spectrum of the battery module; and a plurality of second voltage measurement channels (220), wherein each of the second voltage measurement channels is configured for measuring the voltage of one of the individual battery cell groups of the plurality of cell groups within the battery module during a second measuring phase different from the first measuring phase for determining impedance spectra of the battery cell groups.

Fig. 2

## Description

## TECHNICAL FIELD

Multi-channel diagnostic device for diagnosing a battery module and a method for diagnosing a battery comprised of multiple groups of cells connected in a series string.

## BACKGROUND OF THE INVENTION

The diagnostic of batteries with multiple groups of cells connected in a series string packaged as a module, pack, tray, or another form (hereinafter referred to as a "battery module) is critical to estimating its quality and the health of the cell groups within. Electrical Impedance Spectrometry (EIS) is one method used to perform these diagnostic functions either as a means to measure the entire impedance of the battery module or the individual cell groups within. Today, this is performed by two EIS instruments.

To measure impedance using EIS a multi-sinusoidal excitation current is injected via the positive and negative poles of the battery module. To measure the condition of the cell groups within the battery module, the voltage response of each cell is measured, typically via the battery module connectors to the BMS (referred to as a "multi-channel" EIS measurement).To measure the condition of the overall battery module, a 4-point EIS measurement is performed where the voltage response to the excitation is measured at the terminals of the battery module (referred to as a "single-channel" EIS measurement). The multi-channel EIS measurement of the cell groups requires highly accurate excitation and measurement of the cell voltage. In contrast, the single-channel 4-point measurement at the module terminals is performed at the higher battery module voltage using a less accurate measurement means. Therefore, two different EIS instruments are used for multi-channel and single-channel EIS measurements.

## SUMMARY OF THE INVENTION

There are applications where single-channel and multi-channel EIS measurements are required where both types of EIS measurement are incorporated in a single EIS instrument may be desired.

The problem is solved by the subject-matter of the independent claims. Embodiments are provided by the dependent claims, the following description and the accompanying figures.

The described embodiments similarly pertain to the multi-channel diagnostic device for diagnosing a battery module and the method for diagnosing a battery module. Synergetic effects may arise from different combinations of the embodiments although they might not be described in detail.

Further on, it shall be noted that all embodiments of the present invention concerning a method might be carried out with the order of the steps as described, nevertheless this has not to be the only and essential order of the steps of the method. The herein presented methods can be carried out with another order of the disclosed steps without departing from the respective method embodiment, unless explicitly mentioned to the contrary hereinafter.

Technical terms are used by their common sense. If a specific meaning is conveyed to certain terms, definitions of terms will be given in the following in the context of which the terms are used.

According to a first aspect, a multi-channel diagnostic device for diagnosing a battery module consisting of a plurality of individual battery cell groups is provided. The channel diagnostic device comprises a first voltage measurement channel for measuring the voltage of the battery module during a first measuring phase for determining an impedance spectrum of the battery module, and a plurality of second voltage measurement channels, wherein each of the second voltage measurement channels is configured for measuring the voltage of one of the individual battery cell groups of the plurality of cell groups within the battery module during a second measuring phase different from the first measuring phase for determining impedance spectra of the battery cell groups.

In other words, the multi-channel diagnostic device is able to measure the impedance spectra of the cell groups using the second measurement channels but has an additional voltage measurement channel above the negative and positive poles of the module in order to be able to determine additionally the module impedance. This additional voltage measurement channel can be easily created by, for example, placing an additional cable at the module minus and module plus to the measurement input of the diagnostic device. The multi-channel diagnostic device may inject impedance measurement currents at frequencies starting from < 1 Hz up to the order of kHz. As an example, the range is between 10 mHz and 10 kHz, or preferably between 25 mHz and 1.5 kHz.

Due to the battery module design, modules of one type can also exhibit impedance behavior at frequencies that can also be used in the frequency range above a frequency, where the cell groups show parasitic capacitances. The frequencies, where such parasitic capacitances occur depends on the type of modules, in particular the structure and the distances between the cell groups. Typically, such a behavior can be observed at frequencies of 10 or 15 Hz and higher. The multi-channel device presented herein allows to determine impedance spectra in the complete range from mHZ to kHz. The first measurement channel measuring the response voltages of the module provides valid measurement over all frequencies, and the second measurement channel measuring the response voltages of the cell groups provides valid measurement of the lower frequencies, such that the respective impedance spectra can be determined. This is achieved at low effort by creating the first measurement channel.

A processor of the multi-channel diagnostic device may then perform the diagnosing of the battery based on the measurements of the first measurement phase and on the measurements of the second measurement phase.

The multi-channel diagnostic device may be for example a dedicated device for diagnosing the battery or a battery management system (BMS) or realized as a module within a device such as a BMS or an extension to such a device.

According to an embodiment, the first voltage measurement channel is active in the first measurement phase only and the second voltage measurement channels are active at least in the second measurement phase.

The voltage measurement channels need not to be active in the other respective other measurement phases. This allows, for example, to save resources and a continuous discharge of the battery module as explained further below. A preferred option, however, is that the first measurement channels are active in the first phase only, and the second measurement channels are active during both phases. Alternatively, it would also be possible that the second measurement channels are turned off during the first phase.

There may be different strategies for operating the device. For example, the order is that the first phase is followed by the second phase. This allows for determining the impedance spectrum of the module in the first phase and determining the impedance spectrum of the battery cell groups in the second phase. The impedance spectrum of the battery cell groups may then be used to ensure that the individual impedance spectra are similar indicating that there is no defect cell group, and thus validating the impedance spectrum of the battery module. An alternative strategy could be to change the order. In this case, it could first be detected if the battery cell groups are all right, and if yes, the second phase is executed. If not, the measurement may be stopped, since the spectrum of the battery module would not be valid or useful.

In a less preferred option, the first and the second phases could alternate several times. E.g., the phases may be alternated each time when a new set of frequencies is injected into the battery module.

According to an embodiment, the first measurement channel and the second measurement channels form a measurement channel arrangement that comprises at least one ADC and a multiplexer for detecting the voltages of all individual battery cell groups and the battery module, and for converting the analog voltage signals into digital signals.

According to an embodiment, the multi-channel diagnostic device further comprises a measurement chain including an analog multiplexer connected to each of the cell groups, a filter being connected to the analog multiplexer, and an analog-to-digital converter being connected to the filter, wherein the second voltage measurement channels are configured to use the measurement chain.

The measurement chain may include further circuits such as an amplifier. The measurement chain comprises the hardware circuits which the measured voltages pass. The analog multiplexer is configured to select one voltage, i.e. one of the battery cell groups or the module, at a time such that one measurement channel is "active" at a point in time. The selected voltage corresponds in this case to the voltage of one battery cell group or the module. The voltages are thus provided as a time series to a filter and are then amplified and converted to a digital signal, which is passed to a microprocessor. This embodiment allows to have only one filter and ADC.

According to an alternative embodiment, the multi-channel diagnostic device further comprises measurement chains for each battery cell group and for the battery module, including for each battery cell group a filter and an ADC connected to the respective the cell group, forming the measurement chains for second voltage measurement channels, and for the battery module a filter and an ADC connected to the module, forming the measurement chain for the first voltage measurement channel.

In contrast to the previous embodiment, the voltages of each cell group and of the modules at AD-converted such that for every measurement channel an AD converter is applied. The measurement channels then are digital. The digital signals are then multiplexed by a digital multiplexer and provide to the processor.

According to an embodiment, the first voltage measurement channel further comprises a voltage divider, which is connected at an input side between a positive pole and a negative pole of the battery module, configured to reduce the voltage range of the module to the voltage level range of the second measuring channels.

The voltage divider provides the reduced voltage, for example, at an output side to the analog multiplexer or to the ADC of the first measurement channel, dependent on the realized embodiment.Since the first voltage measurement channel uses the same measurement chain as the second voltage measurement channels, preferably, the voltages that are input to the measurement chain should be similar, i.e. have a same range, which may be, for example, 0-5 V.

According to an embodiment, the first voltage measurement channel has a disconnection point between a pole of the battery module and the first voltage measurement channel for connecting the first voltage measurement channel to the battery module during the first measurement phase and disconnecting the first voltage measurement channel from the battery module during the second measurement phase.

The disconnection point is used to avoid permanent discharge of the battery module via the voltage divider. The disconnection point may be realized by a electromechanical device such as a relay, a semiconductor switch or any other suitable switch.

According to an embodiment, the multi-channel diagnostic device further comprises a processor configured to determine and analyze the impedance spectra of the cell groups regarding capacitive characteristics, and to determine a frequency threshold between lower and higher frequencies, where the impedance spectrum of the cell groups shows the existence of parasitic capacitances; and not to use the impedance spectra of the cell groups above the threshold for diagnosing the battery.

As explained above, the composition of the module may lead to a capacitive behaviour at higher frequencies. This behaviour can be seen in the impedance spectra. That is, the processor can detect the parasitic capacitive behaviour if the impedance spectra deviate from expected values without parasitic capacitive behaviour.

Alternatively, a fixed value, e.g. 10 or 15 Hz, may be configured statically or by an operator as threshold value.

According to an embodiment, the multi-channel diagnostic device comprises a current source that is connected at the positive pole of the battery module and the negative pole of the battery module, which is configured to inject an impedance measurement current into the battery module, wherein the current source is the only current source for injecting an impedance measurement.

An alternative design, which is not preferred in this disclosure, would be to inject the measurement current into each cell group. In this way, the parasitic capacitances would also be avoided. However, this solution would result in a high design and cabling effort.

According to an embodiment, the processor of the multi-channel diagnostic device is configured to use the individual impedance spectra of the battery cell groups to detect an anomaly, and to determine that in the event that the impedance spectra between each other are higher than a threshold, an anomaly exists.

The detection of the anomaly may be one result of the diagnosis. This result may be communication to a server, a client or a user. Further, the battery module impedance spectrum may not be accepted as valid if an anomaly has been detected.

For example, the individual impedance spectra are compared to each other by building pairs or by calculating an average. If, based on the comparison, an anomaly is detected, the responsible cell groups may be identified and considered to be defect or at least in bad condition, or the complete battery module may be considered defect or in bad condition. In this case the cells groups or the battery module might have to be exchanged.

In embodiments, an anomaly is detected if a difference between individual cell groups impedance spectra is higher than a threshold, wherein the threshold is 20 μV/A, preferably 30 μV/A or 40 μV/A, or 70 μV/A, or a value in between.

According to an embodiment, the processor of the multi-channel diagnostic device is configured to use the battery module impedance spectrum as an input feature for an AI-trained network for state prediction of the battery module or to use the battery module impedance spectrum and impedance spectra individual impedance spectra of the battery cell groups as an input feature for an AI-trained network for state prediction of the battery cell groups and/or battery module.

Whether to use the individual impedance spectra of the battery cell groups may depend on the type of battery cells. In case of pouch cells in the module capacitive interaction in the impedance spectra of the cell groups occurs. However, for prismatic or cylindrical cells in a module this is not the case or at least not predominant. Therefore, impedance spectra of individual cell groups can also be used as features of an AI-trained network, if the spectra are not affected with capacitive crosstalk.

A state of the battery module may be a State of Health (SoH) or a State of Charge (SoC), or any other suitable parameter known to a skilled person.

The multi-channel diagnostic device may comprise one or more processors, microcontrollers and/or controllers, herein referred to as processor, for controlling the switch or relay, the injection of the measurement current during the first and the second measurement phases, the measuring, the switching between the phases, for analyzing the impedance spectra, detecting anomalies, calculating the frequency threshold, and perform or control the further steps of the method described herein. The controller may comprise programmable and/or non-programmable logic devices. It may further comprise analog devices such as drivers, e.g. for providing a current for the switches. The voltage measurements are performed by the measurement chain and evaluated by the one or more processor, including the determination of the impedance spectra, running the AI model, and outputting the diagnosis result. The results are stored in a storage, which is also controlled by the one or more microprocessors. The multi-channel diagnostic device may be a battery management system or a part of it. The BMS may comprise further circuits and switches to control and manage the battery.

According to a further aspect, a method for diagnosing a battery module using a multi-channel diagnostic device as described herein is provided. The method comprises the steps: In a first step, during a first measurement phase, a voltage of the battery module is measured for determining an impedance spectrum of the battery module using a first voltage measurement channel. In a further step, during a second measurement phase different from the first measurement phase, the voltage of one of the individual battery cell groups of the plurality of cell groups within the battery module is measured for determining impedance spectra of the battery cell groups using a plurality of second voltage measurement channels. In a further step, the battery is diagnosed based on the measurements of the first measurement phase and on the measurements of the second measurement phase.

For performing the measurements in the first and second measurement phase, a measurement current is injected into the battery module, which is also measured. The measurement current may be composed of a set of multi-sinusoidal signals. A series of multi-sinusoidal signals may be applied to cover the desired frequency range with a desired frequency resolution of the impedance spectra.

The diagnosis relates, for example, to the SoH and/or the SoC. Of course, this can be done for every battery module, such that also the state of the complete battery can be determined or predicted.

The method and the multi-channel diagnostic device correspond to each other. Functional features defined and explained for the multi-channel diagnostic device apply also to the method, and structural features defined and explained for the method apply also to the multi-channel diagnostic device.

According to an embodiment, the method further comprises connecting the first voltage measurement channel to the battery module only during the first measurement phase and activating the second measurement channels at least during the second measurement phase.

According to an embodiment, the method further comprises detecting that an anomaly concerning the cell groups exists, if the individual impedance spectra determined using the measurements during the second measurement phase differ from each other more than a threshold value.

According to an embodiment, the method further comprises using the spectrum of the battery module impedance as input for AI (artificial intelligence) trained model to predict the state of the battery module. to predict the state of the battery module if no anomalies are detected.

According to an embodiment, the method further comprises the steps: determining and analyzing the impedance spectra of the cell groups regarding capacitive characteristics, determining a frequency threshold between lower and higher frequencies, where the impedance spectra of the cell groups show the existence of parasitic capacitances; and disregarding the impedance spectra above the threshold for diagnosing the battery.

These and other features, aspects and advantages of the present invention will become better understood with reference to the accompanying figures and the following description.

## BRIEF DECSRIPTION OF THE DRAWINGS

Fig. 1 shows a diagram of a measuring arrangement.
Fig. 2 shows a block diagram of the principle of the multi-channel diagnostic device.
Fig. 3a shows a diagram of a first variant of the multi-channel diagnostic device.
Fig. 3b shows a diagram of second variant of the multi-channel diagnostic device.
Fig. 4 shows a diagram of the multi-channel diagnostic device.
Fig. 5a shows a block diagram of the first variant of the multi-channel diagnostic device.
Fig. 5b shows a block diagram of the second variant of the multi-channel diagnostic device.
Fig. 6 shows a flow diagram of the method for diagnosing a battery module.

## DETAILED DESCRIPTION OF THE INVENTION

Corresponding parts are provided with the same reference numerals in all figures.

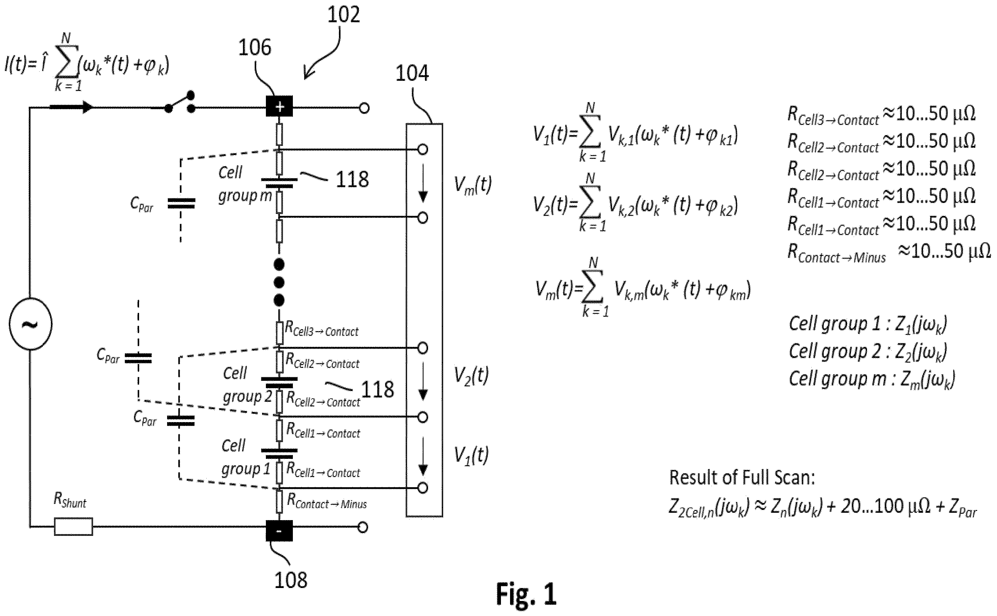

Fig. 1 shows a diagram of a measuring arrangement. A multi-sinusoidal measurement current

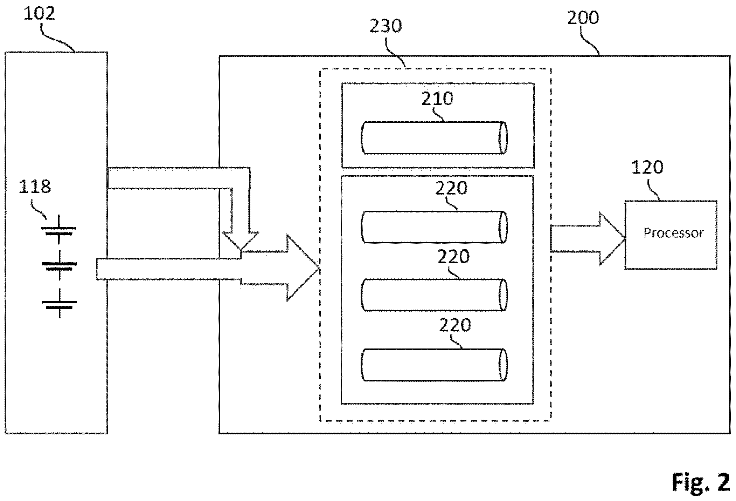

$$I(t) = \hat{I} \sum_{k=1}^{N} (\omega_k*(t) + \varphi_k)$$ is injected by the multi-channel diagnostic device 200 (see Figs. 2 to 6) into the battery module 102 at the positive pole 106 and the negative pole 108 of the battery module 102, with N being the number of frequencies, k the index 1...N of the frequency $\omega_k(t)$ and phase $j_k$, and an amplitude $\hat{I}$. The battery module 102 includes several cell groups 1...m (118). At each cell group 118, a resistor $R_{Cell \to Contact}$ can be assumed representing a contact resistance. The value of these resistors $R_{Cell \to Contact}$ can be assumed to be in the range of 10...50 $\mu\Omega$, summing up to 10...50 $\mu\Omega$ for the two contacts of a cell group 118. The voltages $V_{1...m}(t)$ of each cell group cell group 1...m (118) are tapped and measured using a connector 104 and a cable 310 with lines between the cell groups 118 and the connector 104. The result of a full scan can be written as: $Z_{Cell,n}(j\omega_k) \approx Z_n(j\omega_k) + 20...100$ $\mu\Omega + Z_{Par}$, where $Z_{Cell,n}(j\omega_k)$ is the measurable overall impedance of the nth cell group 118, $Z_n(j\omega_k)$ is the actual impedance of the nth cell group, 20...100 $\mu\Omega$ represents the contact resistances, and $Z_{Par}$ is the parasitic capcitive impedance due to the vicinity of the cell groups 118. The injection of the current may be performed in cycles at different sets of frequencies.

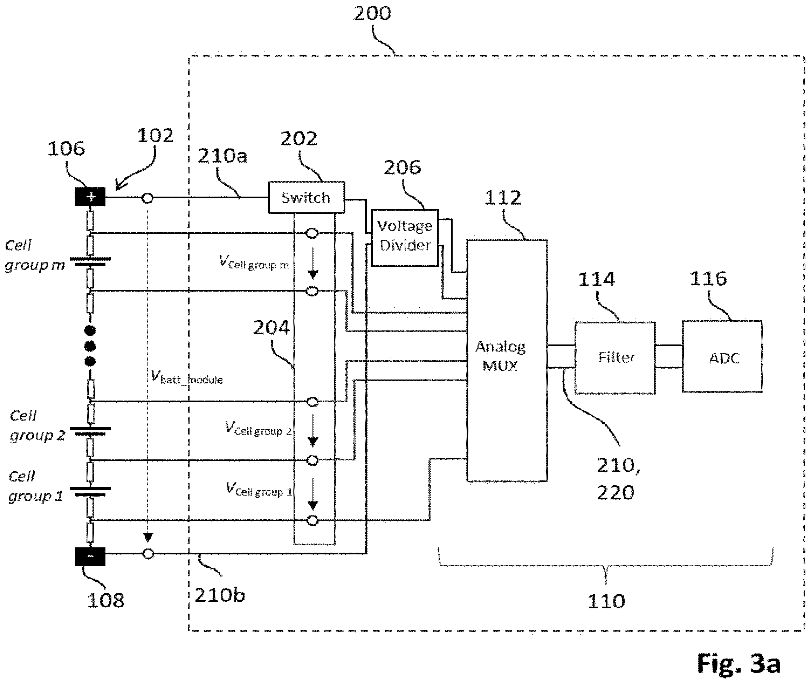

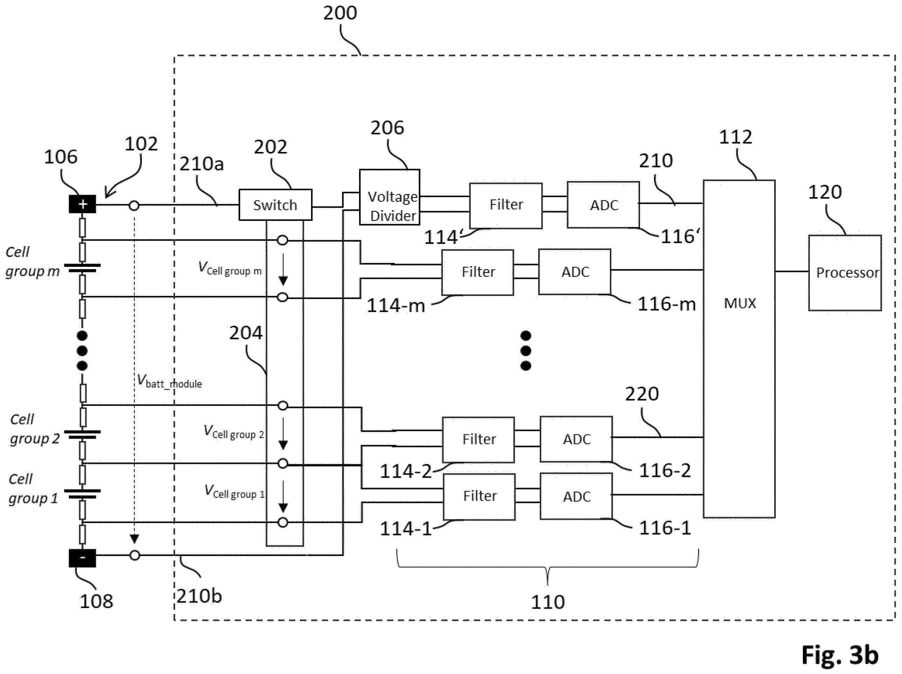

Fig. 2 shows a logical block diagram illustrating the principle of the multi-channel diagnostic device 200. A first voltage measurement channel 210 is provided for measuring the voltage of the battery module 102 for determining an impedance spectrum of the battery module 102. A plurality of second voltage measurement channels 220 is provided, wherein each of the second voltage measurement channels 220 is configured for measuring the voltage of one of the individual battery cell groups 118 of the plurality of cell groups 118 within the battery module 102 for determining impedance spectra of the battery cell groups 118. The measurement channels 210 and 220 form the measurement channel arrangement 230. The measurement channel arrangement 230 comprises at least one ADC and a multiplexer 112 for detecting the voltages of all individual cell groups 118 and the module 102, and for converting the analog voltage signals into digital signals. Examples of implementations are depicted in Figs. 3a and 3b.

The measurement channels 210, 220 can be considered as digital channels in case the voltages are digital converted for each channel at the input side. In this case, the multiplexer 112 may be a digital multiplexer that can be used on output side to provide the signals serially to the processor 120. However, preferably the analog signals at the plurality of measurement channels 220, or at the plurality of measurement channels 220 and measurement channel 210, is (are) parallel analog channels that are analog-multiplexed and then converted to digital signals on the output side. I.e., in this case, the multiplexer 112 is an analog multiplexer. The digital signals are then provided to processor 120.

Fig. 3a shows an embodiment where the measurement channels 210 and 220 are multiplexed by a single analog multiplexer 112. In particular, the measurement channels of the multi-channel diagnostic device 200 are depicted, in form of the analog multiplexer 112, which receives the voltage signals to be measured from the connector 204 and selects an analog signal and passes it to the filter 114, and the analog to digital converter (ADC) 116. If required, one more amplifier may be added, for example between filter 114 and ADC 116. These elements 112, 114, 116 are denominated as measurement chain 110 in this disclosure. They are used to measure the voltages of the cell groups 1...m (118). One particularity of this measurement arrangement is the additional voltage measurement channel 210a, 210b for measuring the voltage of the complete battery module 102. The measurement channel 210a, 210b uses a switch 202 such as a semiconductor switch or relay 202 and a voltage divider 206 in addition to the measurement chain 110.

The voltage of the complete battery module 102 needs to be measured during the first measurement phase. In this phase, the switch 202 is closed, otherwise opened. As an effect, the battery module 102 is not continuously discharged by the voltage divider 206.

Summarized, an additional voltage measurement channel 210, 210a, 210b is created above the negative and positive poles of the battery module 102 in order to be able to determine the battery module impedance. This additional voltage measurement channel can be easily created by placing an additional cable at the module minus 108 and module plus 106 to the measurement input of the diagnostic device 200.

For excited frequencies below a threshold frequency of about 10 or 15 Hz, the sample rate of the ADC is fast enough to switch the input channels of the analog multiplexer 112 during the current injection, so that all single cell groups 118 can be measured quasi simultaneously. This is possible since current and voltage of each cell group 118 is recorded at the same sample, thereby measuring enough samples during the period of the signals to fulfill Shannon's sample theorem. This is advantageous, because it reduces the measurement time to gather the impedance spectra of all cell groups 118 during one excitation injection (over the plus pole 106 and minus pole 108 of the battery module 102) for all frequencies up to the threshold frequency. For example, up to 16 cell groups 118 and the battery module 102 can be measured quasi simultaneously. For excitation currents with frequencies higher than the threshold frequency, the analog multiplexer 112 is fixed at each channel 210, 220 during the current injection phase. This implies that the measurement has to be repeated for each cell group 118. Since the period times of those current signals are low, the additional measurement time for each cell group is very short for example in the order of a few more seconds.

Fig. 3b shows a diagram of the multi-channel diagnostic device 200, which is similar to the one of Fig. 3a, however with an ADC 116-1 ... 116-m, 116' (and filter 114-1 ... 114-m, 114') for every battery cell group 118 and for the battery module 102. In this embodiment, there are m+1 parallel digital channels 210, 220, which are multiplexed by a digital multiplexer 112. The multiplexed digital signals are then provided to the processor or controller 120.

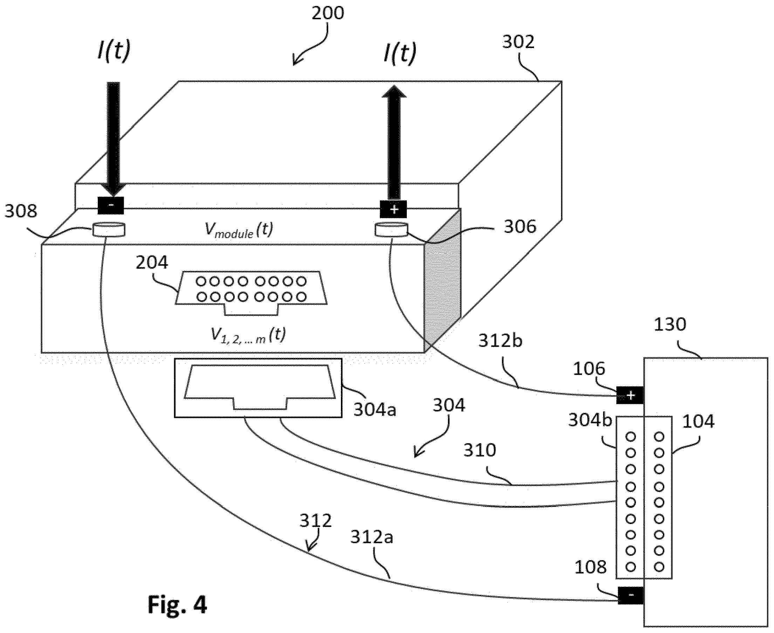

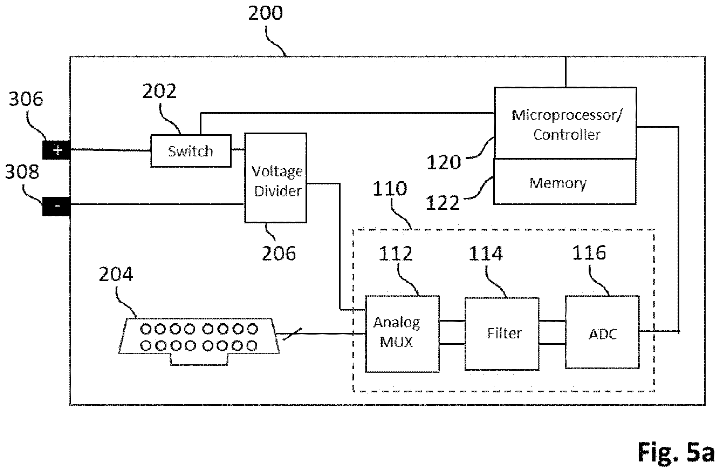

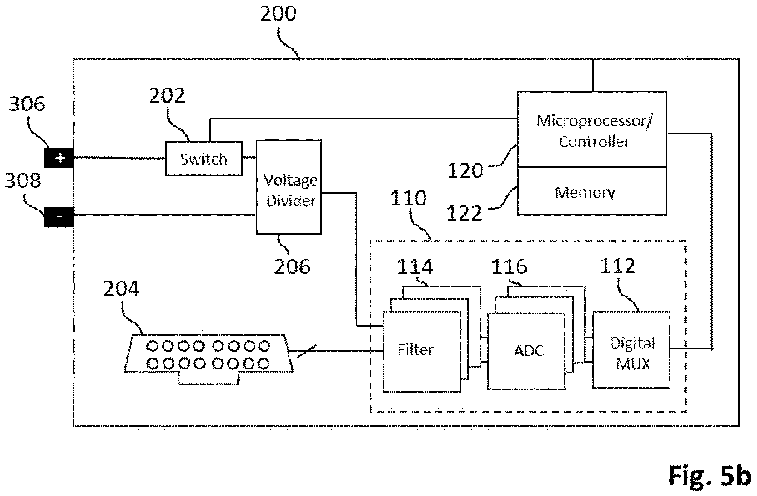

Fig. 4 shows a diagram of the multi-channel diagnostic device 200, and Figs. 5a and 5b show a block diagram of the multi-channel diagnostic device 200. Externally, as depicted in Fig. 4, the multi-channel diagnostic device 200 has a housing 302, a cable 310 with a measurement interface 304 for measuring the voltages $V_{i, 2, ... m}$ (t), represented by connector 304a on multi-channel diagnostic device side and connector 304b on battery 130 side, as well as ports or contacts 306, 308 for injecting the measurement current I(t). For measuring the voltage $V_{module}(t)$, an additional cable 312 with lines 312a, 312b may be used. Alternatively, the voltage $V_{module}(t)$ may be tapped at the internal lines connected to the contacts 306, 308.

Internally, as depicted in Figs. 5a, corresponding to the diagram of the multi-channel diagnostic device 200 in Fig. 3a, the multi-channel diagnostic device 200 comprises the above-mentioned switch 202, which is connected to the voltage divider 206, the measurement chain 110 including the analog multiplexer 112, the filter 114, amplifier and the ADC 116. The output of the voltage divider 206 and the lines of the connector 204 are connected to the analog multiplexer 112. Furthermore, the multi-channel diagnostic device 200 comprises a microprocessor and/or controller 120. The tasks of the microprocessor and/or controller 120 may be, inter alia, one or several of: evaluating the measurement data provided by the ADC 116, controlling the switch 202, processing the measurement data, communicating the processed or evaluated measurement data to a network, a client or a server (not shown), storing results in a storage memory or data base 122, and displaying results. The evaluation of the measurement data may preferably be performed by the processor 120, or externally, or partly by the microprocessor and partly externally. In case that external computing devices are involved, a multi-channel diagnostic system 200 may be defined that includes the multi-channel diagnostic device 200 and the external device. The processor 120 determines the spectrum of the battery module 102 and may use an artificial intelligence model which receives determined spectrum as input to determine the state at least of the battery module 102, or of the battery 130. By strong the results in a memory 122, storage 122, or database 122, a history may be built up, which can again be used by the artificial intelligence model, and which can be provided to a user via a display or a data interface such as a memory card or a data connection to a computing device, a network device, or a cloud device.

That is, Fig. 5a shows an embodiment where the measurement channels 210 and 220 are multiplexed by a single analog multiplexer 112. It is noted that the measurement chain 110 may comprise further elements 112, 114, and 116. For example, the measurement channels 210, 220 shown in Fig. 2 may be realized by an own ADC 116, so that the battery module voltage and the cell group voltages are input to the digital multiplexer 112. Such an implementation is shown in Fig. 5b, corresponding to the diagram of the multi-channel diagnostic device 200 in Fig. 3b. The digital outputs of the ADC 116 may then be provided in parallel to the processor 120, or serially using the digital multiplexer 112.

Further, depending on the number of cells per module, e.g., two analog multiplexers 112 may be used.

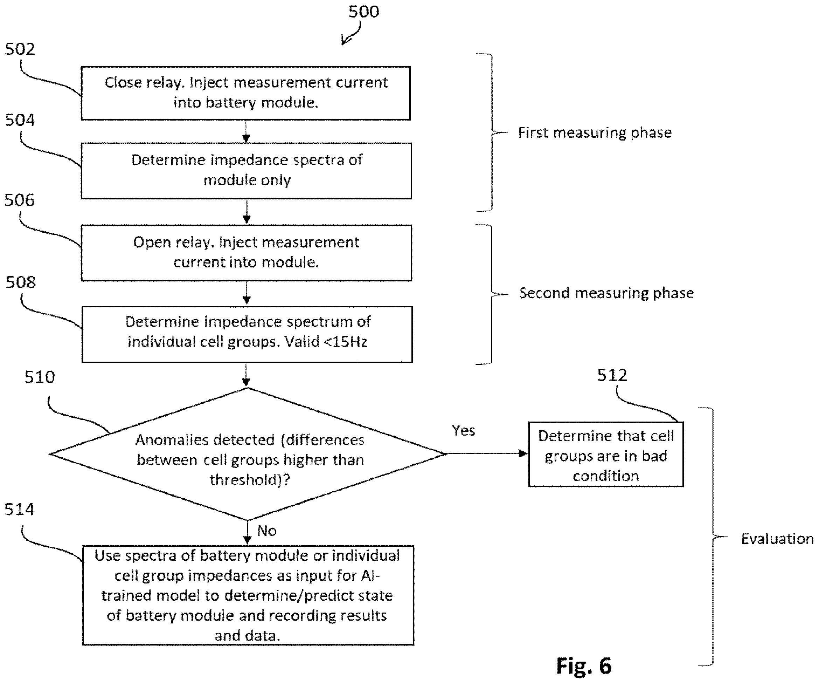

Fig. 6 shows a flow diagram of the method 500 for diagnosing the battery module 102. The method steps 502 ... 514 can be divided into a first measurement phase, comprising the steps 502 and 504, a second measurement phase, comprising the steps 506 and 508, and the evaluation phase comprising the steps 510, 512, and 514. Starting with the step 502, the switch 202, e.g., a relay or semiconductor, between the positive pole 106 of the battery module 102 and the voltage divider 206 is closed, and the sinusoidal, preferably multi-sinusoidal measurement current at frequencies between, for example 25 mHz and 1.5 kHz, is injected into the battery module 102 at the positive and negative poles 106, 108. That is, the first voltage measurement channel 210 is active, and the second voltage measurement channels 220 may be deactivated (or also activated). The battery module impedance measurement channel 210 uses the common measurement chain 110 including filter 114, amplifier and analog-to-digital converter 116.

The only difference to the second voltage measurement channels 220 is the presence of the additional voltage divider 206 to set the voltage level to the level of the second measuring channels 220, i.e., to a voltage level in the range of, for example, 0 to 5 V. The impedance spectrum of the battery module 102 is determined.

The second measurement phase starts at step 506, where again measurement currents at frequencies between, for example 25 mHz and 1.5 kHz are injected into the battery module 102, and the second measurement channels 220 are activated. The switch 202 is opened, thus enabling the voltage measurements of the cell groups 118 only. Now, instead of determining the impedance spectrum of the complete battery module 102, in step 508, the impedance spectra of the battery cell groups 118 are determined. It is noted that in this phase, alternatively, also only currents with frequencies below a threshold, e.g., below 10 or 15 Hz, may be injected into the battery module 102. Due to the parasitic capacitances, only the impedance spectra for frequencies below the threshold frequency are valid.

That is, the multi-channel diagnostic device 200 still allows the recording of the measurement of the impedance spectra on the cell groups up to approx. 10 Hz...15 Hz.

In step 510, anomalies of the battery cell groups 118 are detected using the determined impedance spectra of the individual cell groups. The anomalies are determined by comparing the impedance spectra of the individual cell groups 118 to each other. The frequency range up to the threshold frequency is sufficient to determine whether the impedance behavior is approximately the same for all cell groups 118. If there are differences above a threshold, the cell groups are determined in step 512 to be defect or in bad condition. Depending on the individual differences, single defect cell groups 118 may be identified, or the complete module 102 may be determined to be defect or in bad condition. The threshold may be a threshold for single impedance values or a plurality of impedance values. For example, the differences shall be less than 40-50 $\mu$V/A (amount of impedance) per cell group 118 for intact battery modules 102. If any anomalies are detected, no further measurements are performed. The results are recorded in the memory 122 and displayed to the user or provided to an external client, server or other computing device.

If no anomalies have been detected, the impedance spectra of the battery module 102 and possibly also the battery cell groups 118 are provided to an AI-trained model to predict the state of the SoH and/or SoC as depicted in Fig. 5, step 514. If all single-cell group impedances have a similar impedance behavior up to the threshold frequency, then it can be concluded that estimated SoH or SoC then also corresponds to all cell groups 118 in the module 102. Again, the results and the data are stored in memory, storage or data base 122 and displayed to a user and/or communicated to a further computing device.

The method steps may be repeated for all battery modules 102 forming the battery. The AI model may be a model capable of estimating not only the state of the battery module 102 but also the state of the battery. Another order of the method steps is possible. For example, the first and second measurement phase may be interchanged.

The invention is applicable to any battery arrangement, in particular for high voltage applications such as batteries for electric vehicles, but also for UPS systems, data processing systems, etc.

**DEFINITIONS**

Battery cell group/unit: A unit of cells that can be measured from the outside with respect to their poles. As a rule, a group of cells consists of a single cell or a parallel connection of several cells.

Battery module: A battery module consists of a series of switched battery cell groups and is usually housed in its own housing that provides a module negative and positive pole. Battery modules can be connected in series to form a battery string or a battery pack.

Battery pack/battery string: A series of battery modules represents a battery pack, which represents the entire battery system in an electric car, for example.

Measurement channel: Path from a connection point, here, the connection at a battery cell group or battery module through the analog devices of the multi-channel diagnostic device such as multiplexer, filter, amplifier, ADC, and possibly voltage divider. Due to the multiplexer, the path may be seen at least in parts as "virtual" channel, where the physical channel at the output of the multiplexer is shared by several or all paths.

**Acronyms**

| ADC | Analog to Digital Converter |
| AI | Artificial Intelligence |
| BMS | Battery Management System |
| EIS | Electrical Impedance Spectrometry |
| MUX | Multiplexer |
| SoC | State of Charge |
| SoH | State of Health |

**Reference Numerals**

| 102 | Battery module |
| 104 | Connector |
| 106 | Positive pole of the battery module |
| 108 | Negative pole of the battery module |
| 110 | Measurement chain |
| 112 | Analog or Digital Multiplexer |
| 114(')(1-m) | Filter(s) (for battery module) (for cell groups 1-m) |
| 116(')(1-m) | Analog-to-digital converter (ADC) (for battery module) (for cell groups 1-m) |
| 118 | Battery cell groups |
| 120 | Microcontroller / Controller / Processor |
| 122 | Memory / storage / database |
| 200 | Multi-channel diagnostic device |
| 202 | Switch (Semiconductor/Relay) |
| 204 | Connector at multi-channel diagnostic device |
| 206 | Voltage divider |
| 210(a,b) | Measurement channel for battery module |
| 220 | Measurement channels for battery cell groups |
| 230 | Measurement channel arrangement |
| 302 | Housing of the multi-channel diagnostic device |
| 304 | Measurement interface |
| 304a | Connector of cable on battery side |
| 304b | Connector of cable on multi-channel diagnostic device side |
| 306 | Port/contact for inserting measurement current I(t) (positive port) |
| 308 | Port/contact for inserting measurement current I(t) (negative port) |
| 310 | Cable |
| 312(a,b) | Additional cable (lines) for the additional voltage measurement channel |
| 500 | Method |
| 502...516 | Method steps |

**Claims**

1. Multi-channel diagnostic device (200) for diagnosing a battery module (102) consisting of a plurality of individual battery cell groups (118), comprising

   a first voltage measurement channel (210) for measuring a voltage of the battery module during a first measuring phase for determining an impedance spectrum of the battery module; and a plurality of second voltage measurement channels (220), wherein each of the second voltage measurement channels is configured for measuring the voltage of one of the individual battery cell groups of the plurality of cell groups within the battery module during a second measuring phase different from the first measuring phase for determining impedance spectra of the battery cell groups.

2. Multi-channel diagnostic device according to claim 1, wherein the first voltage measurement channel is active in the first measurement phase only and the second voltage measurement channels are active at least in the second measurement phase only.

3. Multi-channel diagnostic device according to claim 1 or 2, wherein the first measurement channel and the second measurement channels form a measurement channel arrangement that comprises at least one ADC and a multiplexer for detecting the voltages of all individual battery cell groups and the battery module, and for converting the analog voltage signals into digital signals.

4. Multi-channel diagnostic device according to any one of claims 1 to 3, further comprising a measurement chain including an analog multiplexer connected to each of the cell groups, a filter being connected to the analog multiplexer, and an analog-to-digital converter being connected to the filter, wherein the second voltage measurement channels are configured to use the measurement chain.

5. Multi-channel diagnostic device according to any one of claims 1 to 3, further comprising measurement chains for each battery cell group and for the battery module, including

for each battery cell group a filter and an ADC connected to the respective the cell group, forming the measurement chains for second voltage measurement channels; and
for the battery module a filter and an ADC connected to the module, forming the measurement chain for the first voltage measurement channel.

6. Multi-channel diagnostic device according to any one of the previous claims, wherein the first voltage measurement channel further comprises a voltage divider, which is connected at an input side between a positive pole and a negative pole of the battery module, configured to reduce the voltage range of the module to the voltage level range of the second measuring channels.

7. Multi-channel diagnostic device according to any one of the previous claims, wherein the first voltage measurement channel has a disconnection point between a pole of the battery module and the first voltage measurement channel for connecting the first voltage measurement channel to the battery module during the first measurement phase and disconnecting the first voltage measurement channel from the battery module during the second measurement phase.

8. Multi-channel diagnostic device according to any one of the previous claims, wherein the multi-channel diagnostic device further comprises a processor configured

to determine and analyze the impedance spectra of the cell groups regarding capacitive characteristics, and

to determine a frequency threshold between lower and higher frequencies, where the impedance spectrum shows the existence of parasitic capacitances; and
not to use the impedance spectra above the threshold for diagnosing the battery.

9. Multi-channel diagnostic device according to any one of the previous claims, wherein the multi-channel diagnostic device comprises a current source that is connected at the positive pole of the battery module and the negative pole of the battery module, which is configured to inject an impedance measurement current into the battery module, wherein the current source is the only current source for injecting an impedance measurement.

10. Multi-channel diagnostic device according to any one of the previous claims, wherein the processor is further configured to use the individual impedance spectra of the battery cell groups to detect an anomaly, and to determine that in the event that the impedance spectra between each other are higher than a threshold, an anomaly exists.

11. Multi-channel diagnostic device according to any one of the previous claims, wherein the processor is further configured

to use the battery module impedance spectrum as an input feature for an AI-trained network for state prediction of the battery module or
to use the battery module impedance spectrum and impedance spectra individual impedance spectra of the battery cell groups as an input feature for an AI-trained network for state prediction of the battery cell groups and/or battery module.

12. Method for diagnosing a battery module using a multi-channel diagnostic device according to any one of the previous claims, comprising the steps:

measuring a voltage of the battery module during a first measuring phase for determining an impedance spectrum of the battery module using a first voltage measurement channel;
during a second measurement phase different from the first measurement phase, measuring the voltage of one of the individual battery cell groups of the plurality of cell groups within the battery module for determining impedance spectra of the battery cell groups using a plurality of second voltage measurement channels;
diagnosing the battery based on the measurements of the first measurement phase and on the measurements of the second measurement phase.

**13.** Method according to claim 11, wherein the first voltage measurement channel is connected to the battery module only during the first measurement phase and the second measurement channels is activated only during the second measurement phase.

**14.** Method according to any one of claims 12 to 13, further comprising the steps: detecting that an anomaly concerning the cell groups exists, if the individual impedance spectra determined using the measurements during the second measurement phase differ from each other more than a threshold value.

**15.** Method according to any one of claims 12 to 14, further comprising the step: using the spectrum of the battery module impedance as input for KI AI trained model to predict the state of the battery module if no anomalies are detected.

$$I(t)=\hat{I}\sum_{k=1}^{N}(\omega_k * (t)+\varphi_k)$$

$$V_1(t)=\sum_{k=1}^{N} V_{k,1}(\omega_k * (t)+\varphi_{k1})$$

$$V_2(t)=\sum_{k=1}^{N} V_{k,2}(\omega_k * (t)+\varphi_{k2})$$

$$V_m(t)=\sum_{k=1}^{N} V_{k,m}(\omega_k * (t)+\varphi_{km})$$

$R_{Cell3 \rightarrow Contact} \approx 10...50\ \mu\Omega$
$R_{Cell2 \rightarrow Contact} \approx 10...50\ \mu\Omega$
$R_{Cell2 \rightarrow Contact} \approx 10...50\ \mu\Omega$
$R_{Cell1 \rightarrow Contact} \approx 10...50\ \mu\Omega$
$R_{Cell1 \rightarrow Contact} \approx 10...50\ \mu\Omega$
$R_{Contact \rightarrow Minus} \approx 10...50\ \mu\Omega$

Cell group 1 : $Z_1(j\omega_k)$
Cell group 2 : $Z_2(j\omega_k)$
Cell group m : $Z_m(j\omega_k)$

Result of Full Scan:
$$Z_{2Cell,n}(j\omega_k) \approx Z_n(j\omega_k) + 20...100\ \mu\Omega + Z_{Par}$$

## Fig. 1

EP 4 756 445 A1

**Fig. 2**

Fig. 3a

Fig. 3b

Fig. 4

200

Microprocessor/
Controller

Memory

120

122

110

112

Analog
MUX

114

Filter

116

ADC

Switch

202

Voltage
Divider

206

204

306 +

308 −

**Fig. 5a**

Fig. 5b

**Fig. 6**

500

502 — Close relay. Inject measurement current into battery module.

504 — Determine impedance spectra of module only

} First measuring phase

506 — Open relay. Inject measurement current into module.

508 — Determine impedance spectrum of individual cell groups. Valid <15Hz

} Second measuring phase

510 — Anomalies detected (differences between cell groups higher than threshold)?

Yes → 512 — Determine that cell groups are in bad condition

No ↓

514 — Use spectra of battery module or individual cell group impedances as input for AI-trained model to determine/predict state of battery module and recording results and data.

} Evaluation

EP 4 756 445 A1

18

Europäisches
Patentamt

European
Patent Office

Office européen
des brevets

# EUROPEAN SEARCH REPORT

**Application Number**

EP 24 21 8480

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/064240 A1 (ZHOU FANGJIE [CN] ET AL) 2 March 2023 (2023-03-02)<br>* figures 1-9 *<br>* paragraph [0004] - paragraph [0120] *<br>----- | 1-15 | INV.<br>G01R31/367<br>G01R31/389<br>G01R31/392<br>G01R31/396 |
| X | US 2021/223327 A1 (BERGER ANDREAS [AT] ET AL) 22 July 2021 (2021-07-22)<br>* figures 1-14 *<br>* paragraph [0025] - paragraph [0076] *<br>----- | 1,12 | |

**TECHNICAL FIELDS SEARCHED (IPC)**

G01R

The present search report has been drawn up for all claims

| Place of search | Date of completion of the search | Examiner |
|---|---|---|
| Munich | 3 April 2025 | Sedlmaier, Stefan |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 21 8480

This annex lists the patent family members relating to the patent documents cited in the above-mentioned European search report.
The members are as contained in the European Patent Office EDP file on
The European Patent Office is in no way liable for these particulars which are merely given for the purpose of information.

03-04-2025

| Patent document cited in search report | Publication date | Patent family member(s) | Publication date |
|---|---|---|---|
| US 2023064240 A1 | 02-03-2023 | CN 117651875 A | 05-03-2024 |
| | | EP 4166952 A1 | 19-04-2023 |
| | | ES 2981466 T3 | 09-10-2024 |
| | | HU E066301 T2 | 28-07-2024 |
| | | US 2023064240 A1 | 02-03-2023 |
| | | WO 2023024034 A1 | 02-03-2023 |
| US 2021223327 A1 | 22-07-2021 | CN 113138350 A | 20-07-2021 |
| | | DE 102021100497 A1 | 22-07-2021 |
| | | US 2021223327 A1 | 22-07-2021 |

EPO FORM P0459

For more details about this annex : see Official Journal of the European Patent Office, No. 12/82